Europäisches Patentamt

European Patent Office

Office européen des brevets

(11) Publication number: 0 638 905 A2

# EUROPEAN PATENT APPLICATION

(21) Application number: 94112581.7

(22) Date of filing: 11.08.94

(51) Int. Cl.6: G11C 11/412

(30) Priority: 12.08.93 JP 200847/93

(43) Date of publication of application:
15.02.95 Bulletin 95/07

(84) Designated Contracting States:
DE FR GB

(71) Applicant: NEC CORPORATION
7-1, Shiba 5-chome
Minato-ku
Tokyo (JP)

(72) Inventor: Okamura, Hitoshi, c/o NEC
Corporation
7-1, Shiba 5-chome,
Minato-ku
Tokyo (JP)
Inventor: Oguri, Takashi, c/o NEC Corporation
7-1, Shiba 5-chome,
Minato-ku
Tokyo (JP)

(74) Representative: Glawe, Delfs, Moll & Partner
Patentanwälte
Postfach 26 01 62
D-80058 München (DE)

(54) Semiconductor memory integrated circuit.

(57) A memory integrated circuit comprises an array of memory cells each including a latch circuit and a pair of P-channel access transistors. A word line for each row of memory cells is driven by a word driver circuit including an emitter follower at the output stage thereof. The word line is selected by a low-state thereof to turn on the P-channel access transistor, whereby the maximum gate-source voltage of the P-channel access transistor is as high as the supply voltage irrespective of the potential of signal node of the latch circuit. Hence, a higher-speed operation of the memory integrated circuit can be obtained. Moreover, since a word line is selected by a low-state thereof, current flowing in unselected NTL word driver circuits can be reduced. Furthermore, since cutoff is not effected until the potential of signal node becomes equal to the potential of the high-potential voltage source, writing operation can be effected at a high speed so that probability of an $\alpha$-ray error can be reduced.

FIG. 5

## BACKGROUND OF THE INVENTION

### (a) Field of the Invention

The present invention relates to a semiconductor memory integrated circuit and, more particularly, to an improvement in an access transistor of a memory cell and a word driver circuit thereof.

### (b) Description of the Related Art

Semiconductor memory integrated circuits generally include an array of memory cells, each of which comprises a latch circuit implemented by a pair of inverters each comprising either a resistor and a MOS transistor connected in series or a P-channel and an N-channel MOS transistors connected in series, and a pair of N-channel MOS transistors called access transistors. Outside the memory cells, there are provided, for selecting a memory cell, a word line for each row of the memory cells and a pair of bit lines for each column of the memory cells. Each of the access transistors is connected between corresponding one of pair of signal nodes of the latch circuits and corresponding one of bit lines for reading and writing data from and to the memory cell. The word line is connected to the gate electrodes of the access transistors.

In a conventional memory integrated circuit, there is a request for lowering a supply voltage without a malfunction thereof as well as for a higher speed in operation of a memory cell.

There is also a request for lowering a power consumption in a conventional memory integrated circuit

## SUMMARY OF THE INVENTION

In view of the foregoing, an object of the present invention is to provide a semiconductor memory integrated circuit in which writing speed for a memory cell can be improved, in which lower supply voltage can be employed without a malfunction or in which power consumption can be lowered, for a specified combination of a memory cell and a word driver circuit.

A semiconductor memory integrated circuit according to a first aspect of the present invention comprises a substrate, an array of memory cells arranged in rows and columns on the substrate, a word line disposed for each row of the memory cells, a pair of bit lines disposed for each column of the memory cells, and a word driver circuit disposed for each word line and having an emitter follower for driving corresponding word line, each of the memory cells including a pair of P-channel access transistors and a latch circuit having a pair of signal nodes electrically interposed between a first voltage source and a second voltage source, each of said P-channel access transistors being responsive to a low-state of corresponding word line for connecting corresponding one of the signal nodes to corresponding one of the bit lines.

A semiconductor memory integrated circuit according to a second aspect of the present invention comprises a substrate, an array of memory cells arranged in rows and columns on the substrate, a word line disposed for each row of the memory cells and a pair of bit lines disposed for each column of the memory cells, each of the memory cells including a pair of P-channel access transistors and a latch circuit having a pair of signal nodes, each of the P-channel access transistors being formed in a bulk layer of the substrate and responsive to a low-state of corresponding word line for connecting corresponding one of the signal nodes to corresponding one of the bit lines .

With the preferred embodiment of the present invention, the word driver circuit is implemented by a CMOS circuit, a BiNMOS circuit, a BiCMOS circuit, an ECL circuit, or an NTL circuit when the latch circuit of a memory cell is composed of a pair of NMOS inverters, and is implemented by a BiNMOS circuit, a BiCMOS circuit, an ECL circuit, or an NTL circuit when the latch circuit of a memory cell is composed of a pair of CMOS inverters.

With the present invention, by employing a memory cell which includes a latch circuit and P-channel access transistors, an advantage of a large source-gate voltage can be obtained for access transistors, thereby enabling a high-speed writing operation. The present invention provides another advantage of allowing a low voltage operation when the memory cell is combined with a word driver circuit including a bipolar emitter follower at the output stage thereof implemented by a BiNMOS circuit.

The present invention provides still another advantage of reducing power consumption when an NTL word driver circuit is used associated with the memory cell as described above. Moreover, the present invention provides an advantage of securing a high reliability especially when the present invention is applied to a high-resistance resistor memory cells.

## BRIEF DESCRIPTION OF THE DRAWINGS

The above and further objects as well as features and advantages of the present invention will be more apparent from the following description, taken in conjunction with the accompanying drawings in which:

Fig. 1 is a circuit diagram of a conventional memory cell;

Fig. 2 is a circuit diagram of a BiNMOS word driver;

Fig. 3 is a circuit diagram of an NTL word driver;

Fig. 4 is a circuit diagram of a conventional high-resistance load memory cell;

Fig. 5 is a circuit diagram showing a memory cell and its peripheral circuit according to the first embodiment of the present invention;

Fig. 6 is a graph showing dependency of cell current on the gate widths of an access transistor and a drive transistor;

Fig. 7 is a diagram showing a memory cell and its peripheral circuit according to the second embodiment of the present invention; and

Fig. 8 is a circuit diagram of a memory cell and a drive circuit of a DRAM according to a third embodiment of the present invention.

## DESCRIPTION OF THE PREFERRED EMBODIMENTS

Before describing the present invention, problems in conventional semiconductor memory integrated circuits to be solved by the present invention or embodiments thereof will be described for the sake of understanding of the present invention.

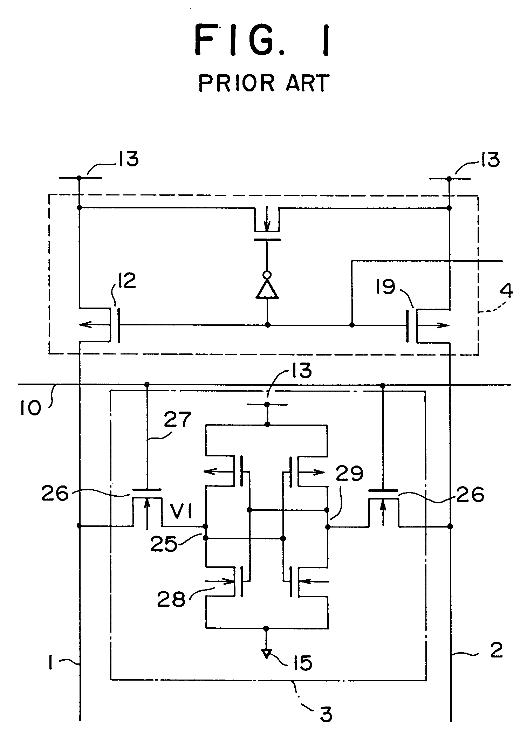

Fig. 1 is a circuit diagram of a memory cell in a conventional SRAM. In the initial state, before readout of a data, suppose that the potential of bit line 1 is relatively high, and the potential of bit line 2 is relatively low and that the potential of signal node 25 in the memory cell 3 is at a low-level and substantially equal to the potential of low-potential voltage source 15, according to a data stored therein. When the potential of word line 10 connected to the gate electrode 27 of access transistor 26, which is of an N-channel MOS type, is raised up to a high potential for selecting the memory cell 3, access transistor 26 is turned on so that current flows from a high-potential power source 13 to a low-potential power source 15 through charge-up MOS transistor 12, access transistor 26 and then drive transistor 28, which is of an N-channel MOS type, in the latch circuit. This current is hereinafter referred to as cell current.

At that time of readout, the potential of bit line 1 falls according to the resistive divisional ratio of charge-up MOS transistor 12 to a combination of access transistor 26 and drive transistor 28. On the other hand, the potential of bit line 2 is raised up to the potential of high-potential voltage source 13 through charge-up MOS transistor 19. Consequently, the potentials of bit lines 1 and 2 are reversed. The difference in potential between bit lines 1 and 2 is amplified by a differential amplifier called a sense amplifier to be supplied to peripheral logic circuits or other semiconductor integrated circuits as the data stored in the memory cell 3 as selected.

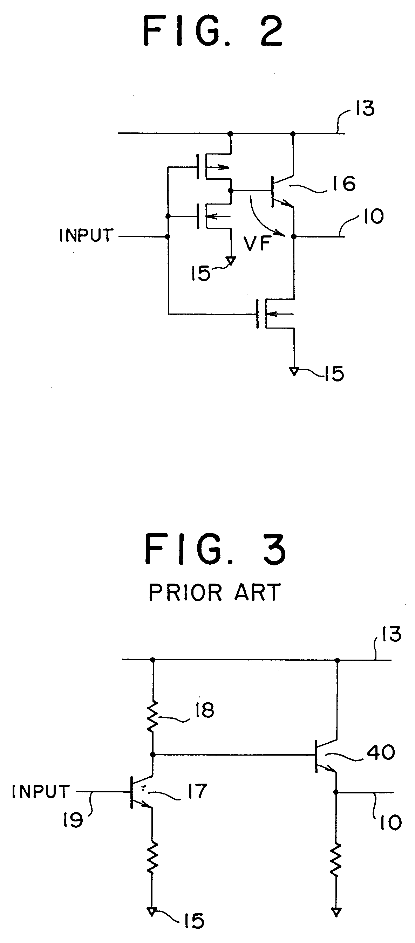

Suppose that, as shown in Fig. 2, a word driver circuit for driving to select word line 10 is a so-called BiNMOS circuit comprising a bipolar transistor and NMOS transistors at the output stage thereof, i.e. an emitter follower with an active pull-down function. Since a pull-up function is effected by an emitter follower scheme in such a BiNMOS circuit, the potential of word line 10 in a high-state is equal to a potential lower than the potential Vcc of high-potential voltage source 13 (with respect to the potential of low-potential voltage source 15) by the emitter-base forward voltage drop VF of output bipolar transistor 16.

As for potential V1 of signal node 25 of the memory cell (with respect to the potential of low-potential voltage source 15), if the memory cell 3 of Fig. 1 is selected and the potential of signal node 25 is lower than an opposite signal node 29, the potential V1 depends on the voltage divisional ratio of a combination of charge-up transistor 12 and access transistor 26 to drive transistor 28, and has a value of several hundred millivolts. Hence the gate-source voltage VGS of the access transistor 26 can be expressed by

$$VGS = Vcc - VF - V1.$$

The gate-source voltage VGS as expressed by the above equation for the N-channel access transistor is not sufficient to obtain a cell current for a quick charge, causing a drawback of a low-speed thereby requiring a large amount of time for inversion of bit lines. This is noticeable when VF becomes relatively large with respect to Vcc as a result of lowering the supply voltage (voltage between the high-potential voltage source and low-potential voltage source). Also, there is another drawback in the conventional memory integrated circuit of this type that the minimum operating voltage is higher by VF as compared to an SRAM employing a CMOS word driver circuit, in which the amplitude of a signal on the word line is substantially equal to a supply voltage. The emitter-base forward voltage drop VF is a physical value determined by a semiconductor material, and is usually 0.8 V or so for silicon.

Now, suppose that the word driver circuit for driving to select word line 10 is an NTL (Non Threshold Logic) circuit without an active pull-down function such as shown in Fig. 3. In the NTL circuit of Fig. 3, since the bipolar transistor 40 is employed in an emitter follower scheme, the potential of word line 10 in a high-state is equal to a potential lower than the potential of high-potential voltage source 13 by the base-emitter forward voltage drop VF of output bipolar transistor 40. Hence, also in this case, the gate-source potential VGS of access transistor 26 in Fig. 1 is expressed by

$$VGS = Vcc - VF - V1.$$

Since access transistor 26 is of an N-channel type, the potential of word lines 10 other than the selected one is pulled down to a low level by supplying H-signal to the input 19 of the NTL word driver of Fig. 3 to turn bipolar transistor 17 on, thereby generating a voltage drop across resistor 18. Hence, when word driver circuits of Fig. 3 are employed in a memory integrated circuit, current flows in word driver circuits other than the selected one. For example, in the case of an SRAM of $2^8$ = 128 words, assuming that a current of 2 mA flows in one NTL circuit outputting a signal of a low potential, the overall current thereof is as large as 2 x 127 = 254 mA. Thus, use of a combination of an NTL word driver circuit of Fig. 3 and a conventional memory cell results in a drawback of a large power consumption.

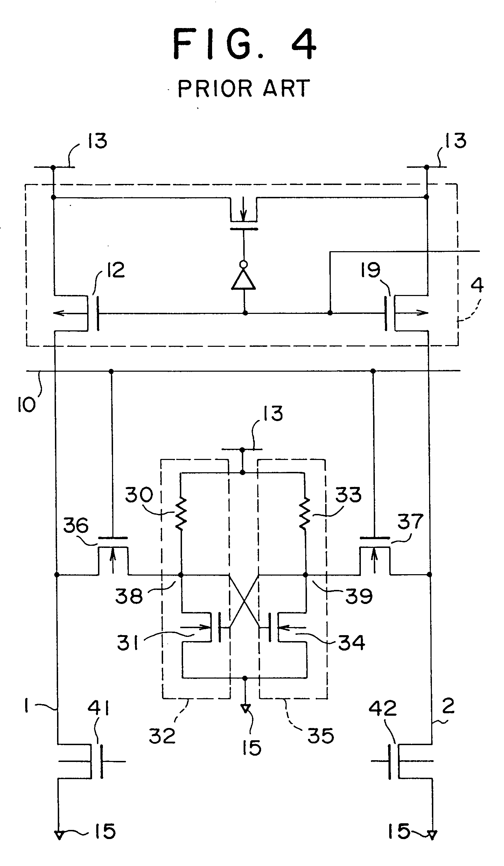

Next, description will be given to a writing operation of another conventional type of a memory cell with reference to Fig. 4. The memory cell comprises a pair of access transistors 36 and 37 implemented by an N-channel MOS transistors and a latch circuit including a pair of inverters 32 and 35, wherein the inverter 32 is implemented by high-resistance resistor 30 and N-channel driver transistor 31 while the inverter 35 is implemented by high-resistance resistor 33 and N-channel drive transistor 34. Each of the drains of drive transistors 31 and 34 constitutes signal node connected to the gate of the other of the drive transistors 31 and 34.

In the initial state, before writing a data to the memory cell in Fig. 4, suppose that signal node 38 is at a high potential while signal node 39 is at a low potential and that bit line 1 is relatively low while bit line 2 is relatively high. When word line 10 is selected and driven up to a high potential during a write period, access transistor 36 is turned on to release the charge stored on signal node 38 to low-potential voltage source 15 through bit line 1 and write transistor 41 depending on a specific data to be written. As a result, signal node 38 is pulled down to the voltage of low potential voltage source 15. At the same time, since access transistor 37 is also turned on, signal node 39 is charged through charge-up MOS transistor 19 up to the potential of high potential voltage source 13 according to the data to be written. In this case, however, when the potential of signal node 39 is charged up to a potential equal to Vcc minus VTN, access transistor 37 is turned off, wherein VTN is the threshold voltage of the N-channel access transistor 37.

After access transistor 37 is turned off, the potential of signal node 39 is charged up to the potential of high-potential voltage source 13 through high-resistance resistor 33. The resistance of resistor 33 is selected, for example, in the range from the gigaohm order to the teraohm order for minimizing the steady-state current of the memory cell, and consequently it takes a large period of time for the potential of signal node 39 to become equal to the potential of high-potential voltage source 13. For example, with the parasitic capacitance of signal node 39 being 10 fF and the resistance of the resistor 33 being 1 TΩ, the CR time constant becomes 10 ms. This is as large as 1000 times the period of 100 MHz clocks, 10 ns.

As still another conventional memory device, Japanese Patent Laid-open Publication No. 2-21654 describes a technique that an access transistor in a stacked memory cell is formed in a common step with a P-channel TFT load element, i.e. both a load and an access transistors are implemented by P-channel TFTs. TFTs, however, generally have a poor MOS characteristic such as a high ON-state resistance.

In the case of a memory cell having high-resistance resistors as shown in Fig. 4 as well as a memory cell having P-channel TFTs described in the publication as mentioned above, when data of the memory cell is reversed, it takes a large amount of time to raise the potential of the then low-potential signal node up to the potential of high-potential voltage source, and consequently, such a state is continued for a prolonged period of time in which a so-called static noise margin of the memory cell is small. If an α-ray falls on the memory cell in such a state, electric charges separated by the α-ray emerges in the semiconductor substrate, destroying the data written in the memory cell. This problem tends to become more noticeable as the supply voltage is lowered or the circuit pattern becomes finer and finer. Thus, conventional high-resistance load memory cells comprising N-channel access transistors or TFT access transistors have a problem that malfunction tends to easily occur due to a low supply voltage or a finer circuit pattern.

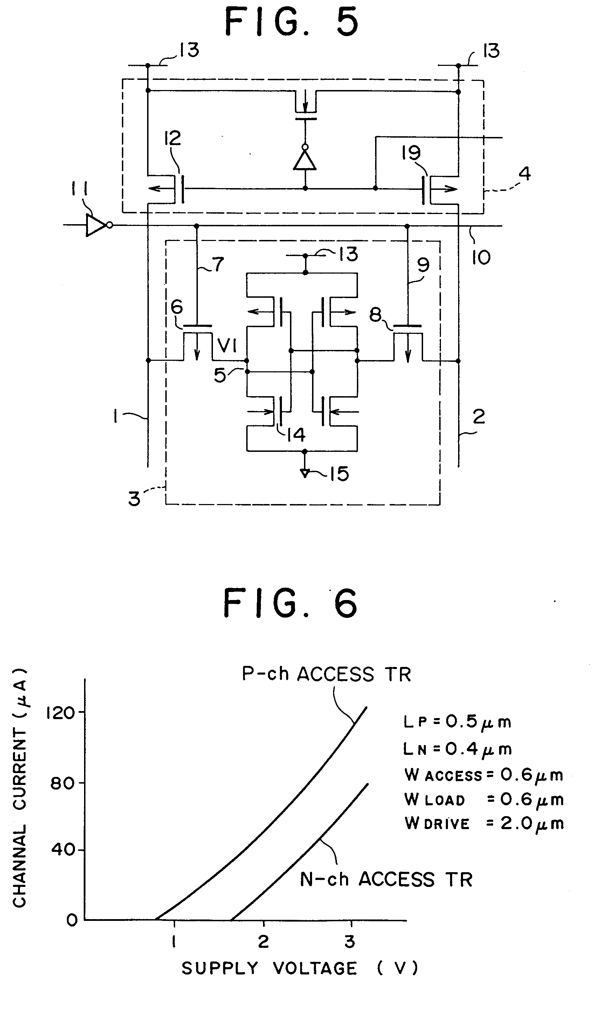

Now, the present invention will be described with reference to the drawings. Fig. 5 shows a memory cell, and a word line and a pair of bit lines connected thereto in an SRAM according to an embodiment of the present invention. The configuration of the memory cell in Fig. 5 is the same as that of the conventional memory cell of Fig. 1 except that first and second access transistors 6 and 8 of Fig. 5 are implemented by P-channel transistors and that word driver circuit 11 is of an inverter type which selects word line through a low-state thereof. Those elements as shown in Fig. 5 are all formed within a bulk of monocrystalline silicon substrate.

First, readout operation will be described. Suppose that in the initial state, bit line 1 is at a potential higher by about 50 millivolts than the potential of bit line 2 due to data read out from another memory cell to bit lines 1 and 2 during a previous readout period and that signal node 5 in the memory cell 3 concerned is in a low-state. When word line 10 is driven to a low potential by operation of word driver circuit 11 for selecting a row including the memory cell 4 of Fig. 5, first and second access transistors 6 and 8 are turned on. As a result, cell current flows from the high-potential voltage source 13 to a low-potential voltage source 15 through a charge-up transistor (P-channel MOS transistor) 12, first access transistor 6 and a drive transistor (N-channel MOS transistor) 14 in the memory cell 4. At this moment, the gate-source voltage VGS of first and second P-channel access transistors 6 is substantially equal to the supply voltage independently of the potential V1 of signal node 5, since the potential of word line 10 in the low-state is equal to the low-potential voltage source in this embodiment, and since the potential of bit line 1 is substantially equal to the potential of high-potential voltage source 13.

Accordingly, VGS is greater by V1 plus VTH as compared to the case of a conventional memory cell comprising N-channel access transistors. When the ratio of potential V1 of signal node to supply voltage Vcc becomes large due to a low supply voltage Vcc, a cell current is obtained in Fig. 5 that is equivalent to or greater than the current obtained by the N-channel access transistor of Fig. 1, by offsetting the fact that gm of a P-channel MOS transistor is generally smaller than that of an N-channel MOS transistor. This advantage is obtained partly because the word driver circuit includes an emitter follower circuit formed by a BiNMOS circuit. Another advantage is such that minimum operating voltage of a memory cell comprising a P-channel access transistor is lower than in the case of N-channel access transistor.

Fig. 6 shows a comparison of cell current between a memory cell including P-channel access transistors and one including N-channel transistors in the case that the supply voltage between high potential voltage source and low potential voltage source is 3 V or lower. In each of the memory cells, channel length of P-channel transistors and N-channel transistors are 0.5 $\mu$m and 0.4 $\mu$m, respectively, while channel widths of access transistors, load transistors and drive transistors are 0.6 $\mu$m, 0.6 $\mu$m and 2.0 $\mu$m, respectively. As evidenced in Fig. 6, P-channel access transistors have an advantage of a higher cell current.

Back to Fig. 2, there is shown an example of a BiNMOS word driver circuit which can be used in the memory integrated circuit of Fig. 5. The BiNMOS word driver circuit includes an emitter follower with an active pull-down function. When such an emitter follower scheme formed by a BiNMOS circuit is employed, the potential of the word line 10 in a high-state does not reach the supply voltage, i.e. the potential in the high-state is lower than the potential of high-potential voltage source by the emitter-base forward voltage drop VF of the bipolar transistor 16. However, since the potential of word line 10 in a low-state is substantially equal to the potential of the low-potential voltage source, a gate-source voltage VGS equal to the supply voltage can be obtained, when P-channel access transistors are employed in a memory cell.

An NTL circuit without an active pull-down function such as shown in Fig. 3 can be also employed as a word driver circuit in Fig. 5. In the NTL circuit of Fig. 3, a word line is driven to a high potential when the word line is not selected to cutoff P-channel access transistors 6 and 8. Therefore, bipolar transistor 17 of the NTL circuit can be off, so that electric power is not consumed in the unselected word driver circuits of Fig. 3. In the case of an SRAM of $2^8$ = 128 words, assuming that a current of 2 mA flows in one NTL circuit outputting a signal of a low potential, a reduction of current by 252 mA (i.e. 2x(127-1) mA) can be obtained as compared to a conventional memory cell in which the N-channel transistor is employed as an access transistor.

When the memory cell of Fig. 5 is selected by word line 10 to receive a cell current, the potential of bit line 1 falls according to the divisional ratio of charge-up MOS transistor 9 to access transistor 6 and drive transistor 14, while, the potential of bit line 2 is raised up to the potential of the high-potential voltage source 13 through charge-up MOS transistor 19. Consequently, the potentials of the bit lines 1 and 2 are reversed. The difference in potential between bit lines 1 and 2 is amplified by a differential amplifier called a sense amplifier not shown to be supplied to peripheral logic circuits or other semiconductor integrated circuits as the readout data of the selected memory cell.

In the present embodiment, since P-channel access transistors are formed within a bulk layer of a silicon substrate, it is possible to provide a higher-speed characteristic as compared to a memory cell including a P-channel access TFT such as described in the publication mentioned above, thereby increasing a writing speed with a consequent improvement of $\alpha$-ray resistance. Also, by combining the memory cell with a word driver circuit having a bipolar emitter follower, the present embodiment provides a semiconductor memory integrated circuit featuring the excellent performance at a lower supply voltage, a higher-speed and a lower power consumption.

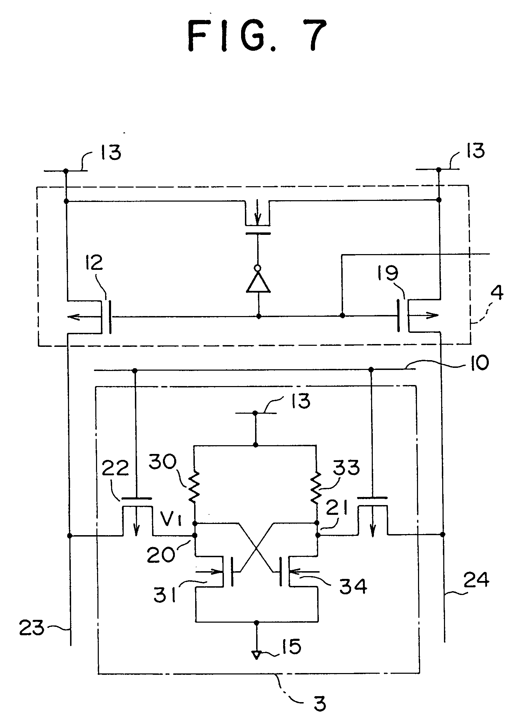

Next, a memory integrated circuit according to a second embodiment will be described with reference to Fig. 7. The memory integrated circuit comprises a memory cell 3 including a pair of inverters each having a N-channel drive transistor and a load resistor. Suppose that, in the initial state before writing a data in the memory cell, signal node 20 is at a low potential while signal node 21 is at a high potential, and that word line 10 has the same potential as low-potential voltage source 15, bit line 23 is at the same potential as high-potential voltage source 13, and bit line 24 is at the same potential as low-potential voltage source 15.

When access transistor 22 is turned on by selecting word line 10, signal node 20 is charged up through charge-up MOS transistor 12. Since the access transistor 22 is of a P-channel type, gate-source voltage thereof is equal to a supply voltage independently of the potential V1 of signal node 20. Hence, signal node 20 is quickly charged through access transistor 22 up to the potential of high-potential voltage source 13. Since the resistance of a P-channel access transistor 22 is as small as several tens kiloohms, a CR time constant for charging up signal node 20 is as small as one-$10^4$ th to -$10^5$ th that of N-channel access transistor. Accordingly, the probability of destruction of memory cell data by $\alpha$-ray significantly reduces, improving the reliability of semiconductor memory integrated circuits.

Since the memory cell of Fig. 7 includes both a P-channel MOS transistor and an N-channel MOS transistor, it may be considered that the memory integrated circuit according to the embodiment has a disadvantage in terms of the degree of integration. However, it can be substantially overcome by employing a known trench separating technique for integration.

In Fig. 7, even when P-channel TFT transistors are used in place of high-resistance resistors 30 and 33 as load elements in the memory cell, similar effects can be expected because an On-state resistance of TFT cannot be made as small as a bulk MOSFET.

Although the present invention is described with reference to the preferred embodiments thereof, the present invention is not limited to such embodiments and it will be obvious for those skilled in the art that various modifications or alterations can be easily made based on the above embodiments within the scope of the present invention.

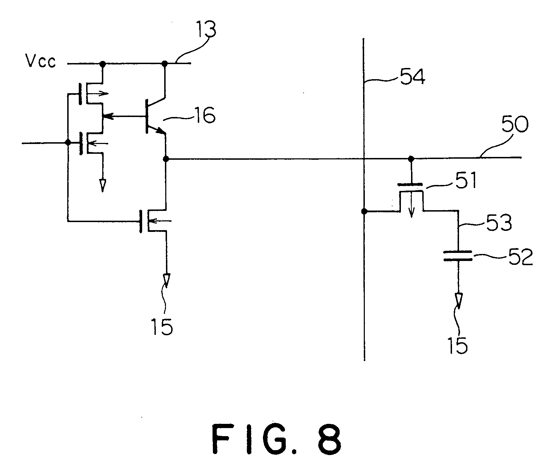

For example, an SRAM has been taken up as an example to describe the present invention. However, it is obvious that the principle of the present invention is also applicable to a DRAM. Fig. 8 exemplarily shows a memory cell of a DRAM according to an embodiment of the present invention.

In Fig. 8, BiNMOS driver circuit of Fig. 2 is employed for driving a word line 50 connected to the gate of cell transistor 51 for connecting a bit line 54 with signal node 53 of a capacitor 52 storing data therein.

Further, the P-channel access transistors are not necessarily formed in a bulk layer, but can be formed as a TFT. Furthermore, word driver circuit of NTL is not necessarily employed in the present invention.

## Claims

1. A semiconductor memory integrated circuit comprising a substrate, an array of memory cells arranged in rows and columns on said substrate, a word line (10) disposed for each row of said memory cells, a pair of bit lines (1, 2) disposed for each column of said memory cells, and a word driver circuit (11) disposed for each said word line and having an emitter follower for driving corresponding said word line (10), and a latch circuit having a pair of signal nodes (5) interposed between a first voltage source (13) and a second voltage source (15), characterized in that each of said memory cells includes a pair of P-channel access transistors (6, 8) each responsive to a low-state of corresponding said word line (10) for connecting corresponding one of said signal nodes (5) to corresponding one of said bit lines (1, 2).

2. A semiconductor memory integrated circuit according to Claim 1 further comprising a pair of charge-up transistors (12, 19) for charging said pair of bit lines (1, 2) from a third voltage source (13), the potential of said third voltage source (13) being equal to the potential of said first voltage source.

3. A semiconductor memory integrated circuit according to Claim 1 or 2 wherein said word driver circuit (11) comprises an NTL circuit.

4. A semiconductor memory integrated circuit according to one of Claims 1 through 3 wherein said latch circuit comprises a pair of CMOS inverters.

5. A semiconductor memory integrated circuit according to one of Claims 1 through 3 wherein said latch circuit comprises a pair of NMOS inverters each including a high-resistance resistor (30, 33).

6. A semiconductor memory integrated circuit according to one of Claims 1 through 3 wherein said latch circuit comprises a pair of NMOS inverters each having a TFT load element.

7. A semiconductor memory integrated circuit comprising a substrate, an array of memory cells arranged in rows and columns on said substrate, a word line (50) disposed for each row of said memory cells, a bit line (54) disposed for each column of said memory cells, and a word driver circuit disposed for each said word line (50) and having an emitter follower for driving corresponding said word line (50), characterized in that each of said memory cells includes a capacitive element (52) having a terminal for storing data and a P-channel access transistor (51) responsive to a low-state of corresponding said word line (50) for connecting said terminal of corresponding capacitive element (52) to corresponding said bit line (54).

8. A semiconductor memory integrated circuit according to Claim 7 wherein said word driver circuit comprise an NTL circuit.

9. A semiconductor memory integrated circuit comprising a substrate, an array of memory cells arranged in rows and columns on said substrate, a word line (10) disposed for each row of said memory cells and a pair of bit lines (1, 2) disposed for each column of said memory cells, each of said memory cells including a pair of access transistors (6, 8) and a latch circuit having a pair of signal nodes (5), characterized in that each of said access transistors (6, 8) is a P-channel MOSFET formed in a bulk layer of said substrate and responsive to a low-state of corresponding said word line (10) for connecting corresponding one of said signal nodes (5) to corresponding one of said bit lines (1, 2).

# FIG. 1
## PRIOR ART

# FIG. 2

# FIG. 3

### PRIOR ART

# FIG. 4

## PRIOR ART

# FIG. 5

# FIG. 6

P-ch ACCESS TR

$L_P = 0.5 \mu m$
$L_N = 0.4 \mu m$
$W_{ACCESS} = 0.6 \mu m$
$W_{LOAD} = 0.6 \mu m$
$W_{DRIVE} = 2.0 \mu m$

N-ch ACCESS TR

CHANNAL CURRENT ($\mu A$)

SUPPLY VOLTAGE ( V )

# FIG. 7

FIG. 8